(19) Europäisches Patentamt
European Patent Office
Office européen des brevets

(11) EP 0 713 140 B1

(12) **EUROPEAN PATENT SPECIFICATION**

(45) Date of publication and mention of the grant of the patent:
**10.06.1998 Bulletin 1998/24**

(51) Int Cl.$^6$: **G03C 8/06**, G03F 7/07

(21) Application number: **94203325.9**

(22) Date of filing: **15.11.1994**

(54) **Imaging element and method for making a printing plate according to the silver salt diffusion transfer process**

Bildelement und Verfahren zur Herstellung einer Druckplatte nach dem Silbersalz-Diffusionübertragungsverfahren

Elément formateur d'image et procédé de fabrication d'une plaque d'impression suivant le procédé de diffusion-transfert de sel d'argent

(84) Designated Contracting States:
**BE DE FR GB NL**

(43) Date of publication of application:
**22.05.1996 Bulletin 1996/21**

(73) Proprietor: **AGFA-GEVAERT N.V.**
**2640 Mortsel (BE)**

(72) Inventors:
- **Berendsen, Jules, c/o Agfa-Gevaert N.V.**
  **B-2640 Mortsel (BE)**
- **Vandenbruwaene,Rik, c/o Agfa-Gevaert N.V.**
  **B-2640 Mortsel (BE)**
- **Vaess, Jos, c/o Agfa-Gevaert N.V.**
  **B-2640 Mortsel (BE)**

(56) References cited:
**EP-A- 0 564 020**
**EP-A- 0 570 795**
**EP-A- 0 602 713**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

1. Field of the invention.

The present invention relates to lithographic printing plates obtained according to the silver salt diffusion transfer process. More in particular the present invention relates to an improvement of the lithographic properties of such printing plates.

2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. For example the United Kingdom Patent Specification 1,241,661 discloses a method for the production of a planographic printing plate consisting of a sheet material comprising an outer hydrophilic colloid layer on the surface of which there is concentrated a silver image stemming from an underlying exposed silver halide emulsion layer by the silver complex diffusion transfer reversal process. The silver image formed on the surface is suitable for printing images in a lithographic printing process using a dampening liquid.

A type of commercial lithographic printing plate precursors of the latter type typically contain on one side of a hydrophobic polymer layer coated paper support in the order given a base layer serving as an anti-halation layer, a silver halide emulsion layer and a surface layer containing physical development nuclei in which the silver image is formed and on the other side a backing layer pack comprising an antistatic layer comprising a high molecular weight polymeric compound having ionic groups e.g. carboxylic sodium salt groups and as outer layer a protective gelatine layer comprising a matting agent .

Such lithographic printing plate precursors, also called imaging elements may be camera exposed or they can be exposed by means of a scan exposure e.g. a laser or L.E.D. exposure. The latter offers the advantage that the preparation of the printing plate is simplified in that a paste-up to be used for the exposure of the imaging element can be completely prepared on a computer. This paste-up prepared on the computer is then transferred to an image setter equiped with e.g. a laser that takes care of the exposure of the imaging element.

Lithographic printing plates of this type obtained according to the silver salt diffusion transfer are generally limited in printing endurance as compared to the aluminium based printing plates that use a diazo composition or photopolymer composition as the photosensitive coating for making the printing plate. These lithographic printing plates obtained according to the DTR-process are generally used for short run printing jobs where the number of copies is not too important but where ease and speed of production of the printing plates are important. One of the requirements therefor is that the capacity of the processing solutions is high so that a sizable amount of printing plates can be produced without refreshing said solutions, what is a time consuming event.

In such short run printing jobs it is also desirable that the number of copies that have to be disposed of at the beginning of the printing job is kept to a minimum in order to increase the production efficiency of the printing process. Unfortunately, with the above described DTR-type lithographic printing plates a fairly large number of copies have to be disposed of at the beginning of the printing job due to unequal ink acceptance, particularly when the activating solution used in the production of said printing plates becomes exhausted.

3. Summary of the invention.

It is an object of the present invention to provide an imaging element and method for making a printing plate therewith according to the silver salt diffusion transfer process, said printing plate having improved lithographic printing

properties in particular a reduced number of copies that have to be disposed of at the start of the printing job even when the activating solution used in the production of said printing plates becomes exhausted.

Further objects of the present invention will become clear from the description hereinafter.

According to the present invention there is provided an imaging element comprising (i) a paper support coated at both sides with a hydrophobic polymer layer, (ii) contiguous to a said hydrophobic polymer layer an antistatic layer containing as an essential component a latex of polythiophene with conjugated polymer backbone together with a polymeric polyanion compound and (iii) in the order given on said support a photosensitive layer comprising a silver halide emulsion and in waterpermeable contact therewith an image-receiving layer comprising physical development nuclei, characterized in that a cover layer containing a hydrophilic colloid binder is contiguous to said antistatic layer.

According to the present invention there is further provided a method for making a lithographic printing plate comprising the steps of image-wise exposing an imaging element as defined above and subsequently developing a thus obtained imaging element by an alkaline processing liquid in the presence of developing agent(s) and silver halide solvent(s).

4. Detailed description of the invention.

It was unexpected and has been found only by extensive research that the number of copies that has to be disposed of at the start of the printing job when using a printing plate obtained according to the DTR-process from an imaging element having a paper support coated with a hydrophobic polymer layer particularly when processed in an activating solution becoming exhausted, is partly determined by the presence in said imaging element of an antistatic high molecular weight polymeric compound having ionic groups .

Likewise unexpectedly it was found that this drawback can be overcome when said printing plate comprises contiguous to said support an antistatic layer containing as an essential component a polythiophene with conjugated polymer backbone together with a polymeric polyanion compound covered with a layer comprising a hydrophilic colloid binder.

Hereby other advantages are obtained as well e.g. a more homogeneous thickness of the antistatic layer, a faster drying of the imaging element after processing (higher productivity), etc..

The production of antistatic coatings from aqueous coating compositions being dispersions of polythiophenes in the presence of polyanions is described in EP-A 440,957.

EP-A 554,588 describes i.a. a material comprising a paper support coated with at least one hydrophobic resin layer wherein said resin layer is coated with a transparent antistatic layer containing as an essential component a polythiophene with conjugated polymer backbone together with a polymeric polyanion compound and with an overlying adhering barrier comprising a polymer latex having hydrophilic functionality

EP-A 602,713 describes a material which comprises a hydrophobic polyester resin support being coated on one or both sides before stretching said support or between a first and a second stretching of said support with a transparent antistatic primer layer, wherein said layer contains a polythiophene with conjugated polymer backbone together with a polymeric polyanion compound and a latex polymer having hydrophilic functionality.

No one skilled in the art would look into these documents in order to find a solution for the problem the present invention intends to solve because the present problem is not mentioned in these disclosures, let alone that a suggestion for the solution is given.

Preferably said polythiophene has thiophene nuclei substituted with at least one alkoxy group, or -O$(CH_2CH_2O)_nCH_3$ group, n being 1 to 4. More preferred polythiophenes for use according to the present invention are made up of structural units corresponding to the following general formula (I) :

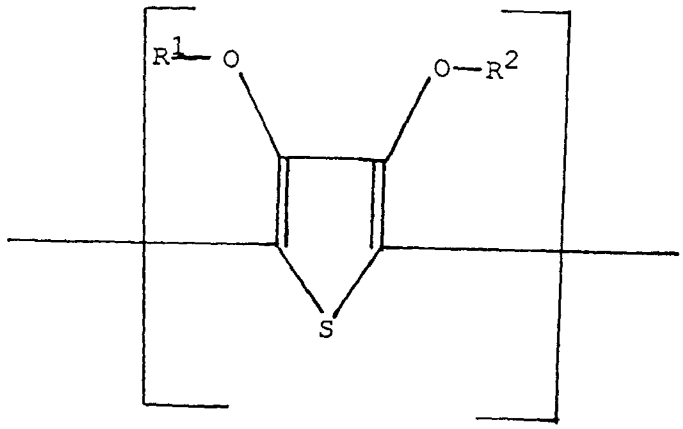

(I)

in which :
each of $R^1$ and $R^2$ independently represents hydrogen or a $C_{1-4}$ alkyl group or together represent an optionally substituted $C_{1-4}$ alkylene group or a cycloalkylene group, preferably an ethylene group, an optionally alkyl-substituted methylene group, an optionally $C_{1-12}$ alkyl- or phenyl-substituted 1,2-ethylene group, a 1,3-propylene group or a 1,2-cyclohexylene group.

The preparation of said polythiophene and of aqueous polythiophene-polymeric polyanion dispersions containing said polythiophene is described in EP-A 440,957 and in the book "Science and Applications of Conducting Polymers" - Papers from the 6th European Physical Society Industrial Workshop held in Lothus, Norway, 28-31 May 1990, p. 92, Edited by W R Salaneck Linkoping University, D T Clark ICI Wilton Materials Research Centre, and E J Samuelson University of Trondheim, published under the Adam Hilger imprint by IOP Publishing Ltd Techno House, Redcliffe Way, Bristol BS1 6NX, England.

The preparation of said polythiophene proceeds in the presence of said polymeric polyanion compounds by oxidative polymerization of 3,4-dialkoxythiophenes or 3,4-alkylenedioxythiophenes according to the following general formula (II) :

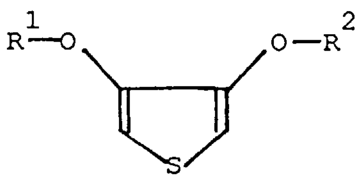

(II)

wherein :
$R^1$ and $R^2$ are as defined in general formula (I), with oxidizing agents typically used for the oxidative polymerization of pyrrole and/or with oxygen or air in the presence of said polyacids, preferably in aqueous medium containing optionally a certain amount of organic solvents, at temperatures of 0 to 100°C.

The polythiophenes get positive charges by the oxidative polymerization, the location and number of said charges is not determinable with certainty and therefore they are not mentioned in the general formula of the repeating units of the polythiophene polymer.

When using air or oxygen as the oxidizing agent their introduction proceeds into a solution containing thiophene, polyacid, and optionally catalytic quantities of metal salts till the polymerization is complete.

Oxidizing agents suitable for the oxidative polymerization of thiophene, according to the present invention, may be the same as those that are described, for example, in J. Am. Soc. 85, 454 (1963) as suitable for the oxidative polymerization of pyrrole. Inexpensive and easy-to-handle oxidizing agents are preferred such as iron (III) salts, e.g. $FeCl_3$, $Fe(ClO_4)_3$ and the iron (III) salts of organic acids and inorganic acids containing organic residues, likewise $H_2O_2$, $K_2Cr_2O_7$, alkali or ammonium persulfates, alkali perborates, potassium permanganate and copper salts such as copper tetrafluoroborate.

Theoretically, 2.25 equivalents of oxidizing agent per mol of thiophene are required for the oxidative polymerization thereof [ref. J. Polym. Sci. Part A, Polymer Chemistry, Vol. 26, p.1287 (1988)]. In practice, however, the oxidizing agent is used in a certain excess, for example, in excess of 0.1 to 2 equivalents per mol of thiophene.

For the polymerization, the thiophenes corresponding to the above general formula (II) a polyacid and oxidizing agent are dissolved or emulsified in an organic solvent or preferably in water and the resulting solution or emulsion is stirred at the envisaged polymerization temperature until the polymerization reaction is completed. By that technique stable aqueous polythiophene/polyanion dispersions are obtained having a solids content of 0.05 to 55% by weight and preferably of 0.1 to 10% by weight.

The polymerization time may be between a few minutes and 30 hours, depending on the size of the batch, the polymerization temperature and the kind of oxidizing agent. The stability of the obtained polythiophene/polyanion dispersion may be improved during and/or after the polymerization by the addition of dispersing agents, e.g. anionic surface active agents such as dodecyl sulfonate, alkylaryl polyether sulfonates described in US-P 3,525,621.

The size of the polythiophene particles in the polythiophene/polyanion dispersion is in the range of from 5 nm to 1µm,, preferably in the range of 40 to 400 nm.

Suitable polymeric polyanion compounds for use together with said polythiophenes, according to the present invention are provided by acidic polymers in free acid form or by a salt of said acidic polymers. The acidic polymers are preferably polymeric carboxylic or sulphonic acids. Examples of such polymeric acids are polymers containing repeating units selected from the group consisting of acrylic acid, methacrylic acid, maleic acid, vinyl sulfonic acid and styrene sulfonic acid or mixtures thereof. The anionic (acidic) polymers used in conjunction with the dispersed polythiophene polymer to form the polythiophene/polyanion dispersion according to the present invention have preferably a content of anionic groups of more than 2% by weight with respect to said polymer compounds to ensure sufficient stability of the dispersion. Suitable acidic polymers or corresponding salts are described e.g. in DE-A 2,541,230, DE-A 2,541,274, DE-A 2,835,856, EP-A 14,921, EP-A 69,671, EP-A 130,115, US-P 4,147,550, US-P 4,388,403 and US-P 5,006,451.

The polymeric polyanion compounds may consist of straight-chain, branched chain or crosslinked polymers. Cross-linked polymeric polyanion compounds with a high amount of acidic groups are swellable in water and are named microgels. Such microgels are disclosed e.g. in US-P 4,301,240, US-P 4,677,050 and US-P 4,147,550.

The molecular weight of the polymeric polyanion compounds being polyacids is preferably in the range from 1,000 to 2,000,000 and more preferably in the range from 2,000 to 500,000. Polyacids within the above criteria are commercially available, for example polystyrene sulfonic acids and polyacrylic acids, or may be produced by known methods (ref. e.g. Houben-Weyl, Methoden der Organischen Chemie, Vol. E 20, Makromolekulare Stoffe, Teil 2, (1987), pp. 141 et seq.).

Instead of the free polymeric polyacids applied in conjunction with the polythiophenes it is possible to use mixtures of alkali salts of said polyacids and non-neutralized polyacids, optionally in the presence of monoacids. Free acid groups of the polyanionic polymer may be allowed to react with an inorganic base, e.g. with sodium hydroxide, to obtain a neutral polymer dispersion before coating.

The weight ratio of polythiophene polymer to polymeric polyanion compound(s) can vary widely, for example from about 50/50 to 15/85.

The polythiophene/polyanion dispersion suitable for use according to the invention may be used in conjunction with a latex polymer having hydrophilic functionality. The weight ratio of polythiophene polymer to said latex can be as low as 1/400 but preferably the polythiophene/polyanion dispersion does not comprise said latex polymer.

Said latex polymer may be a copolyester containing sulphonic acid groups in salt form, but other polyesters, such as the copolyesters having hydrophilic functionality as described e.g. in US-P 3,563,942, 4,252,885, 4,340,519, 4,394,442 and 4,478,907, may be used likewise.

Preferred copolyesters contain a certain amount of sulphonic acid groups in salt form (ref. GB-P 1,589,926) and as described in US-P 4,478,907 and EP-A 78,559 and for raising their glass transition temperature (Tg) contain an amount of particular co-condensated cross-linking agent(s). Such copolyesters contain e.g. recurring ester groups derived from ethylene glycol and an acid mixture containing (i) terephthalic acid, (ii) isophthalic acid, (iii) 5-sulphoisophthalic acid whose sulpho group is in salt form and (iv) a polyfuctional acid producing crosslinks.

In a particularly preferred embodiment the copolyester is a copolyester containing recurring ester groups derived from ethylene glycol and an acid mixture containing terephthalic acid, isophthalic acid and 5-sulphoisophthalic acid whose sulpho group is in salt form, said acid mixture consisting essentially of from 20 to 60 mole % of isophthalic acid, 6 to 10 mole % of said sulphoisophthalic acid, 0.05 to 1 mole % of cross-linking agent being an aromatic polycarboxylic acid compound having at least three carboxylic acid groups or corresponding acid generating anhydride or ester groups, the remainder in said acid mixture being terephthalic acid.

Although said copolyesters, having hydrophilic functionality through said sulfonic acid (salt) group are preferred, likewise addition (co)polymers having hydrophilic functionality may be used.

According to a particular embodiment of the present invention the coating composition of the antistatic layer contains in admixture to the already mentioned polythiophene/polyanion dispersion and copolyester latex, an addition polymer or copolymer in latex form and having hydrophilic functionality. Such (co)polymers are disclosed in e.g. EP-A 386,529, US-P 3,861,924, Research Disclosure n° 162, October 1977 p. 47-49 item 16 258, US-P 4,225,665 and US-P 4,689,359 . Further polyurethanes having hydrophilic properties as disclosed in US-P 4,388,403 may be used

as latex polymers.

In the coating composition for coating an antistatic layer according to the present invention, said addition polymer is preferably a copolymer formed from 45 to 70 % by weight of a lower ($C_1$-$C_4$) alkyl methacrylate, 25 to 50 % by weight of butadiene and from 2 to 5 % by weight of an ethylenically unsaturated carboxylic acid.

An example of a very suitable addition polymer applied in latex form and having hydrophilic functionality is a copolymer of vinylidene chloride and an unsaturated carboxylic acid as described e.g. in US-P 3,649,336. Preferably such an addition copolymer is a copolymer formed from 60 to 90 % by weight of vinylidenechloride, 9 to 30 % of a lower ($C_1$-$C_4$) alkyl methacrylate and from 1 to 5 % by weight of an ethylenically unsaturated carboxylic acid.

For improving the mechanical strength of the antistatic layer a film-forming latex, e.g. on the basis of co(vinylidene chloride-methyl acrylate-itaconic acid), and/or preferably a water-soluble polymeric colloid binder, e.g. polyvinyl alcohol or gelatin, may be added together with a therefor suited hardening agent.

Before coating, a surface active agent may be added to the coating composition for improving the spreading of the antistatic layer. For that purpose anionic as well as non-ionic wetting agents may be used, e.g. a $C_{12}$-$C_{18}$ alkylphenol polyethyleneoxide ether such as dodecylphenol polyethylene oxide ether, p-nonyl-phenoxypolyglycidol, iso-octyl-phenylene-$(O-CH_2-CH_2)_8-O-CH_2-COOH$ sold under the tradename AKYPO OP80 by CHEMY, the Netherlands, or saponine. It is clear that other surface-active agents may be used and that their favourable influence on reduction of surface resistivity can be checked by simple tests. A survey of surface-active agents is given e.g. in Tensid-Taschenbuch Herausgegeben von Dr. Helmut Stache - Carl Hanser Verlag München Wien (1979).

On drying the antistatic coating any solvent and water is removed by evaporation which may proceed at room temperature or at elevated temperature, e.g. in the range of 40 to 140°C.

After drying, the thickness of the antistatic layer is e.g. from 0.001 to 1 µm, more preferably fom 0.030 to 0.30 µ depending i.a. on the desired conductivity of the antistatic coating.

Preferably only one side of said support is coated with said antistatic layer, most preferably the side which will be coated with the photosensitive layer. On the other hand, the antistatic layer according to the invention can be coated on both sides of the paper support coated at both sides with a hydrophobic polymer layer. In that case, each antistatic layer may be coated with a cover layer comprising a hydrophilic colloid binder contiguous to said antistatic layer. Alternatively, one antistatic layer can contain a hydrophobic organic polymer having a glass transition temperature ($T_g$) of at least 40°C as disclosed in EP-A 593,111 or can be covered with a layer comprising a polymer latex wherein said polymer latex has hydrophilic functionality as described in EP-A 554,588.

The hydrophilic colloid binder comprised in the cover layer is usually a protein, preferably gelatin. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole,, polyvinyl pyrazole, polyacrylamide, polyacrylic acid, and derivatives thereof, in particular copolymers thereof. Natural substitutes for gelatin are e.g. other proteins such as zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives such as hydroxyalkyl cellulose, carboxymethyl cellulose, phthaloyl cellulose, and cellulose sulphates.

The coating composition of said cover layer preferably also contains colloidal silicium dioxide in a weight ratio to the above mentioned hydrophilic colloidal binder in the range from 0.2 to 5, more preferably in a weight ratio from 0.5 to 3, most preferably in a weight ratio from 0.7 to 1.5. The surface area of said colloidal silicium dioxide is preferably at least 100 $m^2/g$, more preferably between 200 $m^2/g$ and 600 $m^2/g$.

Said cover layer as defined above can comprise a latex polymer having hydrophilic functionality as described e. g. in US-P 5,006,451. Latex polymers having hydrophilic functionality and their use in photographic elements is well known in the art, for example from US-P 4,689,359. The weight ratio of hydrophilic colloid binder to said latex can be as low as 1/50 but preferably the cover layer does not comprise a said latex polymer.

Suitable latex polymers for use in the cover layer are copolymers of (1) one or more polymerizable monomers selected from the group consisting of styrene, vinylidene chloride, acrylonitrile, alkyl acrylates and alkyl methacrylates with (2) one or more substituted polymerizable monomers selected from the group consisting of styrenes, alkyl acrylates and alkyl methacrylates that have been substituted with a hydrophilic functional group such as an aminoalkyl salt group, an hydroxyalkyl group or carboxylic acid group.

Examples of group (I) comonomers are : ethyl acrylate, ethyl methacrylate, butyl acrylate and butyl methacrylate.

Examples of group (II) monomers are : 2-aminoethyl methacrylate hydrochloride, 2-hydroxyethyl acrylate, 2-hydroxyethyl methacrylate, N(3-aminopropyl)methacrylate hydrochloride, p-aminostyrene hydrochloride and itaconic acid.

Preferred latex polymers for use in said cover layer are copolymers of unsaturated carboxylic acids with vinylidene chloride, acrylonitrile, (meth)acrylate monomers, styrene and mixtures thereof. Preference is given to latex polymers containing at least 50 mol % vinylidene chloride repeating units and repeating units with carboxyl functional groups, e.g. itaconic acid and acrylic acid groups.

Particularly suited are vinylidene chloride copolymers with copolymerized unsaturated carboxylic acids as hydrophilic functionality, e.g. as described in US-P 4,543,386, US-P 5,006,451 and GB-P 1,234,755. Preferred copolymers of that type contain at least 50 mol % and more preferably at least 70 mol % of vinylidene chloride.

Particularly preferred latex polymers for use in said cover layer are terpolymers of vinylidene/methyl (meth)acrylate/ itaconic acid containing 70 to 90 mol % vinylidene chloride, 5 to 25 mol % methyl (meth)acrylate and 1 to 10 mole % itaconic acid.

Typically the cover layer is coated at a dry weight coverage of from about 0.10 to about 3.00 g/m$^2$.

The coating composition of said cover layer may further contain in conjunction with the hydrophilic colloidal binder e.g. a matting agent, coating aid and/or friction lowering substance, e.g. wax particles, silicon resin or fluorinated polymer preferably in colloidal particulate form.

The photographic silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 µm , preferably from 0.25 to 0.45 µm.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $0.5*10^{-7}$ and $10^{-5}$ mole per mole of $AgNO_3$.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value near the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions can be found in e.g. Product Licensing Index, Vol. 92, December 1971, publication 9232, p. 107-109.

Apart from negative-working silver halide emulsions that are preferred for their high light-sensitivity, use can be made also of direct-positive silver halide emulsions that produce a positive silver image.

For instance, direct-positive silver halide emulsions that mainly forms an internal image as described in e.g. EP-A 365,926 and US-P 3,062,651 may be employed. Alternatively, prefogged direct-positive silver halide emulsions with internal or, more preferably, with external electron traps as disclosed in EP-A 94201899.5 and EP-A 481,562 are also suitable for use in connection with the present invention.

For instance, direct-positive emulsions of the type described in US-A 3,062,651 may be employed. In direct-positive emulsions a non-hardening fogging agent such as stannous chloride and formamidine sulphinic acid can be used.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

The layer containing physical development nuclei is in waterpermeable contact with the photosensitive silver halide emulsion layer. Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e. g. developing agents or the complexed silver.

A support in accordance with the present invention is a paper coated at both sides with a hydrophobic polymer layer. Said paper has preferably a weight in the range from 50 $g/m^2$ to 300 $g/m^2$, more preferably a weight in the range from 100 $g/m^2$ to 200 $g/m^2$. The hydrophobic polymer layer is preferably a poly-Alpha-olefin, usually poly-ethylene or poly-propylene. Said hydrophobic polymer layer is preferably coated at a weight in the range from 5 $g/m^2$ to 50 $g/m^2$, more preferably at a weight in the range from 10 $g/m^2$ to 35 $g/m^2$.

If only one side of said support is coated with said antistatic layer, the other side is preferentially coated with a subbing layer contiguous to the hydrophobic polymer layer of the support. A preferred subbing layer is a layer containing a hydrophilic colloid binder.

Between the support and the silver halide emulsion layer there is preferably provided a base layer that preferably contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titaniumdioxide can be present in the base layer. Further this layer can contain hardening agents, matting agents, e.g. silica particles, and wetting agents. Suitable matting agents preferably have an average diameter of 2-10 µm and more preferably between 2 µm and 5 µm. The matting agents are generally used in a total amount in the imaging element of 0.1 $g/m^2$ to 2.5 $g/m^2$. At least part of these matting agents and/or light reflection pigments may also be present in the silver halide emulsion layer and/or in the cover layer, the most part, preferably at least 80% by weight however preferably being present in said base-layer. As a further alternative the light reflecting pigments may be present in a separate layer provided between the antihalation layer and the photosensitive silver halide emulsion layer. Like the emulsion layer the base layer is coated preferably at a pH value near the isoelectric point of the gelatin in the base layer.

In a preferred variant of this embodiment in connection with the present invention a backing layer comprising a hydrophilic colloid binder is provided at the non-light sensitive side of the support. This layer which can serve as anticurl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a multiple layer pack e.g. a double layer pack.

According to a preferred embodiment in connection with the present invention the roughness of the backing layer package is adjusted such that an arithmetical mean deviation of profile $R_a$ of more than 0.7 is obtained. $R_a$ being obtained in accordance with the following formula:

$$R_a = (1/m) \cdot \int_0^m |f(x)| \, dx \ (\mu m)$$

with m being 0.8

The profile of said backing layer package is measured with a perthometer Mahr Perthen S6P containing as measuring head RTK 50 (tradenames of Feinpruef Perthen GmbH, Goettingen, Germany) equipped with a diamond stylus with a diameter of 5 µm under a pressure of 1.0 mN.

When the $R_a$-value of the back of the printing plate is less than 0.7 the number of copies that have to be disposed of at the start of the printing process will generally be larger. However, if $R_a$ is below 0.15 an improvement may be obtained when the back of the printing plate is at least partially wetted when mounting it on the printing cylinder.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value near the isoelectric point of the gelatin. But instead of or together with gelatin, use can be made of one or more other natural and/or synthetic hydrophilic colloids as disclosed before.

The hydrophilic layers of the photographic element, especially when the binder used is gelatin, can be hardened with appropriate hardening agents such as those of the vinylsulfone type e.g. methylenebis(sulfonylethylene), aldehydes e.g. formaldehyde, glyoxal, and glutaraldehyde, N-methylol compounds e.g. dimethylolurea and methyloldimethylhydantoin, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

The imaging element used according to the present invention may further comprise various kinds of surface-active agents in the photographic emulsion layer or in at least one other hydrophilic colloid layer. Examples of suitable surface-active agents are described in e.g. EP-A 545452. Preferably compounds containing perfluorinated alkyl groups are used.

The imaging element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The above described DTR mono-sheet imaging element in connection with the present invention is exposed in an apparatus according to its particular application, e.g. a conventional process camera containing a conventional light source or a high intensity short time exposure such as e.g. a laser containing device. Subsequently the imaged element is developed with an alkaline processing liquid in the presence of developing agent(s) and silver halide solvent(s).

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Said developing agents may be contained in an alkaline processing liquid but are preferably contained in one or more layers of the photographic element. In the latter case the alkaline processing liquid merely serves as an alkaline activating liquid.

The pH of said alkaline liquid is preferably between 9 and 14, more preferably between 10 and 13 and may be established by an organic and/or inorganic alkali agent. Examples of suitable alkali agents are e.g. sodium hydroxide, carbonates, phosphates, alkanolamines or mixtures thereof.

The alkaline processing liquid preferably also contains a preserving agent having antioxidation activity, e.g. sulphite ions. Further may be present a thickening agent, fog inhibiting agents e.g. a benzotriazole which is known to improve the printing endurance, calcium-sequestering compounds, anti-sludge agents, development accelerators and hardeners including latent hardeners.

Suitable silver complexing agents also called silver halide solvents for use in accordance with the present invention are e.g. thiosulphate or thiocyanate in an amount ranging from 5 g to 20 g per liter. Other interesting silver halide complexing agents are e.g. sulphite, amines, 2-mercaptobenzoic acid, cyclic imide compounds such as e.g. uracil, 5,5-dialkylhydantoins, alkyl sulfones and oxazolidones.

Further silver halide solvents for use in connection with the present invention are alkanolamines. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers, preferably di- or poly-thioethers as disclosed in e.g. US-P-4.960.683 and EP-A 554,585.

Still further suitable silver halide solvents are meso-ionic compounds, preferably 1,2,4-triazolium-3-thiolates as disclosed in e.g. EP-A 554,585.

Combinations of different silver halide solvents can be used and it is also possible to incorporate at least one silver halide solvent into a suitable layer of the imaging element and to add at least one other silver halide solvent to the developing or activating solution. Preferably they are comprised in the alkaline processing liquid.

The development step is preferably followed by a neutralization of the surface of the imaged element by guiding the element through a neutralization liquid having a pH between 4 and 8. The neutralization liquid preferably contains a buffer e.g. a phosphate buffer, a citrate buffer, an amine or a mixture thereof. The neutralization solution can further contain bactericides, e.g. phenol, thymol or 5-bromo-5-nitro-1,3-dioxan as described in EP-150,517, wetting agents e.g. saponins or pluronics etc.. The liquid can also contain substances which influence the hydrophobic / hydrophilic

balance of the printing plate obtained after processing of the DTR element, e.g. silica. Finally the neutralization solution can contain wetting agents, preferably compounds containing perfluorinated alkyl groups.

To improve the differentiation between the hydrophobic silver image and the hydrophilic background the alkaline processing liquid and/or neutralization liquid preferably contain one or more hydrophobizing agents, e.g. those described in US-P-3,776,728, and US-P-4,563,410. Preferred hydrophobizing agents are mercapto-1,3,4-thiadiazoles as described in DE-A 1,228,927 and in US-P 4,563,410, 2-mercapto-5-alkyl-oxa-3,4-diazole and long chain (at least 5 carbon atoms) alkyl substituted mercaptotetrazoles.

A lithographic printing plate is thus obtained.

The invention will now be illustrated by the following example without however the intention to limit the invention thereto. All parts are by weight unless otherwise specified.

EXAMPLE 1 (Comparative example)

Preparation of the silver halide emulsion coating solution.

A silver chlorobromide emulsion composed of 98 mole% of chloride, 1.7 mole% of bromide and 0.3 mole% of iodide was prepared by the double jet precipitation method. The average silver halide grain size was 0.4µm (diameter of a sphere with equivalent volume) and contained Rhodium ions as internal dopant. The emulsion was orthochromatically sensitized and stabilized by 1-phenyl-5-mercapto-tetrazole.

A base layer coating solution was prepared having the following composition:

| | |
|---|---|
| gelatin | 5.5% |
| carbon black | 0.76% |
| silica particles (5µm) | 1.6% |

Preparation of 3,4-ethylenedioxy-thiophene

The 3,4-disubstituted thiophenes of the formula (II) can be obtained by processes known in principle by reacting the alkali metal salts of 3,4-dihydroxy-thiophene-2,5-dicarboxylic esters with the appropriate alkylene vic-dihalides and subsequently decarboxylating the free 3,4-(alkylene-vic-dioxy)thiophene-2,5-dicarboxylic acids (see, for example, Tetrahedron 1967 Vol. 23, 2437-2441 and J. Am. Chem. Soc. 67 (1945) 2217-2218).

Preparation of poly(3,4-ethylenedioxy-thiophene) dispersion

Into 1000 ml of an aqueous solution of 20 g of polystyrene sulfonic acid (109 mmol of $SO_3H$ groups) with number-average molecular weight (Mn) 40,000, were introduced 3.6 g of potassium peroxidisulfate and 5.6 g of 3,4-ethylenedioxy-thiophene. The thus obtained reaction mixture was stirred for 24 h at 20 °C and a dispersion with solids content of about 2.5 % was obtained.

Preparation of the imaging elements I.

The emulsion coating solution and base layer coating solution were simultaneously coated by means of the cascade coating technique to the subbed side of a double-sided polyethylene layer coated paper support provided with a backing layer such that the base layer coating was coated directly to the side of the support opposite to the side containing said backing layers. The support consisted of paper with a weight of 140 g/m$^2$ ,that was coated on both sides with 2 * 19 g/m$^2$ polyethylene and subbed on one side with 0.5 g/m$^2$ gelatin. The emulsion layer was coated such that the silver halide coverage expressed as $AgNO_3$ was 1.5g/m$^2$ and the gelatin content was 1.5g/m$^2$. The emulsion layer further contained 0.15g/m$^2$ of 1-phenyl-4,4'-dimethyl-3-pyrazolidone and 0.25g/m$^2$ of hydroquinone. The base layer was coated such that the amount of gelatin in the coated layer was 3g/m$^2$.

The backing layer contained 2.5 g/m$^2$ of gelatin, 1.8 g/m$^2$ of the antistatic agent co(tetraallyloxyethane / methacrylate / acrylic acid-K-salt) polymer, 0.8 g/m$^2$ of a matting agent consisting of transparent spherical polymeric beads of 3 micron average diameter according to EP-A 80225, 0.05 g/m2 of hardening agent triacrylformal and 0.021 g/m$^2$ of wetting agent $F_{15}C_7$-$COONH_4$.

The thus obtained element was dried and subjected to a temperature of 40°C for 5 days and then the emulsion layer was overcoated with a layer containing PdS as physical development nuclei, hydroquinone at 0.4g/m$^2$ and formaldehyde at 100mg/m$^2$.

Preparation of the imaging element II

An imaging element II was prepared similar to imaging element with the exception that the backing layer was substituted by a packet of two backing layer, obtained as follows. The antistatic layer was applied to the non-subbed side of said subbed double-sided polyethylene layer coated paper support from a mixture of 140 ml of the above prepared poly(3,4-ethylenedioxy-thiophene) dispersion, 858 ml of water and 2 ml of a 5 % solution in water of wetting agent AKYPO OP 80 (tradename). The coating proceeded at a wet coverage of 50 $m^2/l$ resulting after drying at 115 °C in a dry solids coverage of 70 $mg/m^2$. A transparent practically colourless antistatic layer was obtained. Onto said antistatic layer was coated a cover layer containing 2.5 $g/m^2$ of gelatin, 0.8 $g/m^2$ of a matting agent consisting of transparent spherical polymeric beads of 3 micron average diameter according to EP-A 80225, 0.05 $g/m^2$ of hardening agent triacrylformal and 0.021 $g/m^2$ of wetting agent $F_{15}C_7$-$COONH_4$.
The following alkaline processing solution was prepared:

| | |
|---|---|
| sodium hydroxide (g) | 30 |
| sodium sulphite anh. (g) | 33 |
| potassium thiocyanate (g) | 20 |
| 3-mercapto-4-acetamido-5-n.heptyl-1,2,4-triazole (g) | 0.15 |
| water to make | 1 l |

The following neutralization solution was prepared:

| | |
|---|---|
| citric acid | 10 g |
| sodium citrate | 35 g |
| sodium sulphite anh. | 5 g |
| phenol | 50 mg |
| water to make | 1 l |

The above described imaging elements were image-wise exposed and processed at 30°C with the above described alkaline processing solution, subsequently neutralized at 25 °C with the neutralization solution described above and dried. Four processing runs were tested:

Test 1: Imaging elements I were processed as described above at a ratio of 2 $m^2$/day for 20 days;
Test 2: Imaging elements II were processed as described above at a ratio of 2 $m^2$/day for 20 days;
Test 3: Imaging elements I were processed as described above at a ratio of 5 $m^2$/day for 20 days;
Test 4: Imaging elements II were processed as described above at a ratio of 5 $m^2$/day for 20 days;

The last printing plate of each test was mounted on the same offset printing machine (A B Dick 9860) and was used for printing under identical conditions. Commercial A B Dick 1020 was used at a 5 % concentration in an aqueous solution containing 10 % isopropanol as dampening solution and K+E 123 W, marketed by Kast+Ehinger, A.G., Germany, was used as ink. A compressible rubber blanket was used. The printing results are given in table 1.

Table I

| Test | Ink acceptance [a] | Quality of copy[b] | | | |
|---|---|---|---|---|---|
| | | 10th | 20th | 50th | 100th |
| 1 | 50 | 4 | 3 | 2 | 1 |
| 2 | 20 | 2 | 1 | 1 | 1 |
| 3 | > 100 | 4 | 4 | 3 | 3 |
| 4 | 25 | 3 | 2 | 1 | 1 |

a) Ink acceptance : number of copies that has to be disposed off before the copy becomes acceptable
b) Quality of print : this is a visual relative evaluation
1 : good
2 : acceptable
3 : non acceptable
4 : very bad

Evaluation:

It is clear from the results of table 1 that printing plates obtained after processing in a more (test 3 and 4) or less (test 1 and 2) exhausted processing solution have much better printing properties when in said processing solution imaging elements II (imaging elements according to the present invention) have been processed than when in said processing solution imaging elements I (comparative imaging elements) have been processed.

## Claims

1. An imaging element comprising (i) a paper support coated at both sides with a hydrophobic polymer layer, (ii) contiguous to a said hydrophobic polymer layer an antistatic layer containing as an essential component a latex of polythiophene with conjugated polymer backbone together with a polymeric polyanion compound and (iii) in the order given on said support a photosensitive layer comprising a silver halide emulsion and in waterpermeable contact therewith an image-receiving layer comprising physical development nuclei, characterized in that a cover layer containing a hydrophilic colloid binder is contiguous to said antistatic layer.

2. An imaging element according to claim 1 wherein said hydrophilic colloid binder is gelatin.

3. An imaging element according to claim 1 or 2 wherein said cover layer comprises colloidal siliciumdioxide.

4. An imaging element according to claim 3 wherein said cover layer comprises colloidal silicium dioxide in a weight ratio to said hydrophilic colloidal binder in the range from 0.2 to 5.

5. An imaging element according to any of claims 1 to 4 wherein the thickness of said antistatic layer is from 0.001 to 1 µm.

6. An imaging element according to any of claim 1 to 5 comprising only one antistatic layer.

7. An imaging element according to claim 6 wherein said one antistatic layer is comprised between said support and said photosensitive layer.

8. An imaging element according to any of claim 1 to 7 wherein said support is a paper coated at both sides with a poly-Alpha-olefin layer.

9. An imaging element according to any of claims 1 to 8 having a backing layer comprising a hydrophilic colloid binder at the non-light sensitive side of said support

10. A method for making a lithographic printing plate comprising the steps of image-wise exposing an imaging element according to any of claims 1 to 9 and subsequently developing a thus obtained image-wise exposed imaging element by means of an alkaline processing solution in the presence of a silver halide solvent and developing agent.

## Patentansprüche

1. Ein bilderzeugendes Element, das (i) einen beidseitig mit einer hydrophoben polymeren Schicht überzogenen Papierträger, (ii) angrenzend an die hydrophobe polymere Schicht eine Antistatikschicht mit als wichtigstem Bestandteil einem Latex von Polythiophen mit einer konjugierten polymeren Hauptkette zusammen mit einer polymeren Polyanionverbindung und (iii) der angegebenen Reihe nach auf dem Träger eine lichtempfindliche Silberhalogenid-Emulsionsschicht und in wasserdurchlässiger Beziehung dazu eine physikalische Entwicklungskeime enthaltende Bildempfangsschicht enthält, dadurch gekennzeichnet, daß angrenzend an die Antistatikschicht eine ein hydrophiles Kolloidbindemittel enthaltende Deckschicht vorliegt.

2. Ein bilderzeugendes Element nach Anspruch 1, dadurch gekennzeichnet, daß das hydrophile Kolloidbindemittel Gelatine ist.

3. Ein bilderzeugendes Element nach Anspruch 1 oder 2, dadurch gekennzeichnet, daß die Deckschicht kolloidales Siliciumdioxid enthält.

4. Ein bilderzeugendes Element nach Anspruch 3, dadurch gekennzeichnet, daß die Deckschicht kolloidales Siliciumdioxid in einem Gewichtsverhältnis zwischen 0,2 und 5, bezogen auf das hydrophile Kolloidbindemittel, enthält.

5. Ein bilderzeugendes Element nach irgendeinem der Ansprüche 1 bis 4, dadurch gekennzeichnet, daß die Stärke der Antistatikschicht zwischen 0,001 und 1 μm liegt.

6. Ein bilderzeugendes Element nach irgendeinem der Ansprüche 1 bis 5, das nur eine Antistatikschicht enthält.

7. Ein bilderzeugendes Element nach Anspruch 6, dadurch gekennzeichnet, daß die Antistatikschicht zwischen dem Träger und der fotoempfindlichen Schicht vorliegt.

8. Ein bilderzeugendes Element nach irgendeinem der Ansprüche 1 bis 7, dadurch gekennzeichnet, daß der Träger ein beidseitig mit einer Poly-α-Olefinschicht überzogenes Papier ist.

9. Ein bilderzeugendes Element nach irgendeinem der Ansprüche 1 bis 8, das an der nicht lichtempfindlichen Seite des Trägers eine ein hydrophiles Kolloidbindemittel enthaltende Rückschicht enthält.

10. Ein Verfahren zur Herstellung einer lithografischen Druckplatte, das die Stufen der bildmäßigen Belichtung eines gemäß irgendeinem der Ansprüche 1 bis 9 definierten bilderzeugenden Elements und der darauffolgenden Entwicklung eines so erhaltenen bildmäßig belichteten bilderzeugenden Elements mittels einer alkalischen Verarbeitungsflüssigkeit in Gegenwart einer Entwicklersubstanz und eines Silberhalogenid-Lösungsmittels umfaßt.

**Revendications**

1. Elément formateur d'image comprenant (i) un support en papier couché sur les deux faces avec une couche de polymère hydrophobe, (ii) contiguë à ladite couche polymère hydrophobe, une couche antistatique contenant, à titre de composant essentiel, un latex de polythiophène possédant un squelette de polymère conjugué, conjointement avec un composé polyanionique polymère, et (iii) dans l'ordre donné sur ledit support, une couche photosensible comprenant une émulsion à l'halogénure d'argent et, en contact de perméabilité à l'eau avec cette dernière, une couche réceptrice d'image comprenant des germes de développement physique, caractérisé en ce qu'une couche de protection contenant un liant colloïdal hydrophile est contiguë à ladite couche antistatique.

2. Elément formateur d'image selon la revendication 1, dans lequel ledit liant colloïdal hydrophile est la gélatine.

3. Elément formateur d'image selon la revendication 1 ou 2, dans lequel ladite couche de protection comprend du dioxyde de silicium colloïdal.

4. Elément formateur d'image selon la revendication 3, dans lequel ladite couche de protection comprend du dioxyde de silicium colloïdal dans un rapport pondéral audit liant colloïdal hydrophile dans le domaine de 0,2 à 5.

5. Elément formateur d'image selon l'une quelconque des revendications 1 à 4, dans lequel l'épaisseur de ladite couche antistatique s'élève de 0,01 à 1 μm.

6. Elément formateur d'image selon l'une quelconque des revendications 1 à 5, comprenant une seule couche antistatique.

7. Elément formateur d'image selon la revendication 6, dans lequel ladite couche antistatique est comprise entre ledit support et ladite couche photosensible.

8. Elément formateur d'image selon l'une quelconque des revendications 1 à 7, dans lequel ledit support est un papier couché sur les deux faces avec une couche de poly-alpha-oléfine.

9. Elément formateur d'image selon l'une quelconque des revendications 1 à 8, possédant une couche dorsale comprenant un liant colloïdal hydrophile sur le côté non photosensible dudit support.

10. Procédé pour fabriquer un cliché d'impression lithographique, comprenant les étapes consistant à exposer en forme d'image un élément formateur d'image selon l'une quelconque des revendications 1 à 9 et à développer par

la suite un élément formateur d'image exposé en forme d'image ainsi obtenu, au moyen d'une solution de traitement alcaline en présence d'un solvant de l'halogénure d'argent et d'un agent développateur.